(19) **Europäisches Patentamt**
**European Patent Office**
**Office européen des brevets**

(11) **EP 2 857 855 A1**

(12) **EUROPEAN PATENT APPLICATION**
published in accordance with Art. 153(4) EPC

(43) Date of publication:
**08.04.2015 Bulletin 2015/15**

(21) Application number: **12877987.3**

(22) Date of filing: **31.05.2012**

(51) Int Cl.:
**G01R 31/36** (2006.01)

(86) International application number:
**PCT/JP2012/003605**

(87) International publication number:
**WO 2013/179350 (05.12.2013 Gazette 2013/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Sanyo Electric Co., Ltd.**
**Moriguchi-shi, Osaka 570-8677 (JP)**

(72) Inventors:
• **OKUDA, Yasuo**
  **Osaka-shi, Osaka 540-207 (JP)**
• **IWASAKI, Toshiya**
  **Osaka-shi, Osaka 540-207 (JP)**
• **OUE, Yasuhiro**
  **Osaka-shi, Osaka 540-207 (JP)**
• **IKEBE, Hayato**
  **Osaka-shi, Osaka 540-207 (JP)**

(74) Representative: **Appelt, Christian W.**
**Boehmert & Boehmert**
**Anwaltspartnerschaft mbB**
**Patentanwälte Rechtsanwälte**
**Pettenkoferstrasse 20-22**
**80336 München (DE)**

(54) **CONTROL METHOD AND CONTROL APPARATUS USING SAME**

(57) An acquisition unit 68 acquires state of health of a storage battery provided to supply electric power, in which the state of health shows a smaller value as the storage battery deteriorates. A display unit 58 performs notification when state of health acquired by the acquisition unit 68 is smaller than a first threshold value. When the acquisition unit 68 has not acquired state of health for a predetermined period, the display unit 58 performs notification if the elapsed period from the manufacture of the storage battery is longer than a second threshold value.

FIG.2

CONVERSION APPARATUS

14

EP 2 857 855 A1

**Description**

[TECHNICAL FIELD]

The present disclosure relates to a control technique, and particularly to a control method for a storage battery and a control apparatus using the control method.

[BACKGROUND ART]

An electronic device, including a portable electronic device, can be conventionally driven by a battery. In such an electronic device, when the amount of remaining power in the battery pack runs out during operation, a program or data may be destroyed. In order to prevent such destruction, the amount of remaining power of the battery is displayed. However, the life or a fault of a battery is sometimes not displayed. Accordingly, malfunction of a battery is detected, information on the malfunction is detected, and the malfunction of the battery is determined based on the information (see Patent Literature 1, for example).

[PRIOR ART REFERENCE]

[PATENT LITERATURE]

[Patent Literature 1] Japanese Unexamined Patent Application Publication No. 2005-321983.

[DISCLOSURE OF INVENTION]

[PROBLEM(S) TO BE SOLVED BY THE INVENTION]

An example of information on malfunction of a battery is state of health (SOH). In such a situation, the inventors have recognized the following problem. The SOH is generally derived by charging and discharging a battery. Accordingly, for a battery used in a method in which SOH cannot be estimated or for a malfunctioning battery, SOH cannot be measured. However, notification of degrees of deterioration of such batteries is also desired.
The present disclosure has been made in view of such a situation, and a purpose thereof is to provide a technique for giving notice of a degree of deterioration of a storage battery.

[MEANS TO SOLVE THE PROBLEM(S)]

To solve the problem above, a control apparatus according to one embodiment of the present invention includes an acquisition unit that acquires state of health of a storage battery provided to supply electric power to a load, in which the state of health shows a smaller value as the storage battery deteriorates, and a notification unit that performs notification when state of health acquired by the acquisition unit is smaller than a first threshold value. When the acquisition unit has not acquired state of health for a predetermined period, the notification unit performs notification if the elapsed period from the manufacture of the storage battery is longer than a second threshold value.
Another embodiment of the present invention is a control method. The method includes acquiring state of health of a storage battery provided to supply electric power to a load, in which the state of health shows a smaller value as the storage battery deteriorates, and performing notification when acquired state of health is smaller than a first threshold value. When state of health has not been acquired for a predetermined period in the acquiring, notification is performed in the performing notification if the elapsed period from the manufacture of the storage battery is longer than a second threshold value.
Optional combinations of the aforementioned constituting elements, and implementations of the invention in the form of methods, apparatuses, systems, recording media, and computer programs may also be practiced as additional modes of the present invention.

[ADVANTAGEOUS EFFECTS OF INVENTION]

The present disclosure enables notification of a degree of deterioration of a storage battery.

[BRIEF DESCRIPTION OF DRAWINGS]

Embodiments will now be described, by way of example only, with reference to the accompanying drawings which are meant to be exemplary, not limiting, and wherein like elements are numbered alike in several Figures, in which:

Figs. 1A-1C are diagrams that each show a configuration of a power distribution system according to an embodiment of the present invention;
Fig. 2 is a diagram that shows a configuration of a conversion apparatus shown in Figs. 1A-1C;
Figs. 3A-3D are diagrams that each show a screen displayed on a display unit shown in Fig. 2;
Figs. 4A-4B are diagrams that each show a time transition of display on the display unit shown in Fig. 2;
Figs. 5A-5D are diagrams that each show a screen displayed on the display unit shown in Fig. 2;
Fig. 6 is a flowchart that shows a procedure of notification of a battery life performed by the conversion apparatus shown in Fig. 2;
Fig. 7 is a flowchart that shows a procedure of determination based on SOH shown in Fig. 6; and
Fig. 8 is a flowchart that shows a procedure of determination based on an elapsed period shown in Fig. 6.

[MODE FOR CARRYING OUT THE INVENTION]

A general description will be given before the present invention is specifically described. An embodiment of the present invention relates to a power distribution system in which a solar battery is connected in parallel to a commercial power system, power is supplied from a commercial power supply, the solar battery, and a storage battery to a load, and the storage battery is charged. If the commercial power supply fails, power from the solar battery or the storage battery is supplied to a load. While power is supplied from the commercial power supply, the storage battery may be set to not discharge. Since the performance of such a storage battery will deteriorate, notification of the degree of deterioration or the life of a storage battery is desired in order to prevent the situation where the storage battery cannot be used when it needs to be used. The degree of deterioration or the life of a storage battery is determined based on state of health (SOH). The SOH is measured at the time of charging or discharging. However, in order to handle the case where discharge control is provided in which SOH cannot be measured, a power distribution system according to the present embodiment issues a warning when SOH has not been updated for a predetermined period of time, based on the elapsed time after the manufacture of the storage battery.

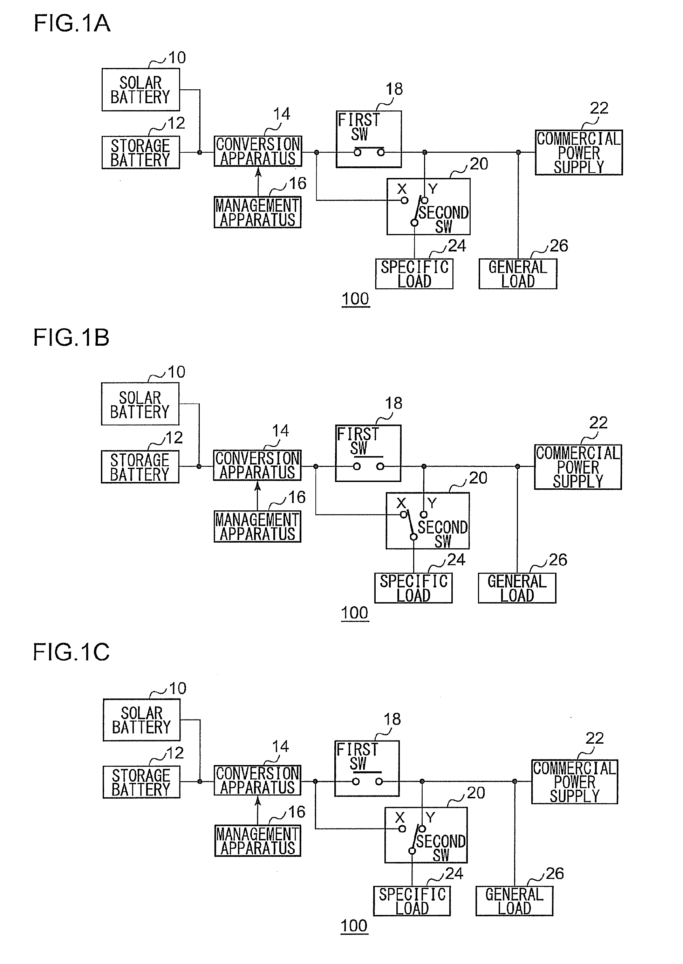

Each of Figs. 1A-1C shows a configuration of a power distribution system 100 according to an embodiment of the present invention. In Fig. 1A, the power distribution system 100 comprises a solar battery 10, a storage battery 12, a conversion apparatus 14, a management apparatus 16, a first SW 18, a second SW 20, a specific load 24, and a general load 26. The power distribution system 100 is connected to a commercial power supply 22. The commercial power supply 22 is an alternating-current (AC) power supply for supplying power from an electric power company. Fig. 1A corresponds to a configuration of the power distribution system 100 when the commercial power supply 22 is not failing (hereinafter, referred to as a "normal state").

The solar battery 10 is a power device that uses photovoltaic effect and converts optical energy directly into electric power. As the solar battery 10, a silicon solar battery, a solar battery made of materials including various compound semiconductors, or a dye-sensitized solar battery (an organic solar battery) may be used. The solar battery 10 outputs generated power. The storage battery 12 is charged with power generated from a renewable energy source, such as power generated by the solar battery 10, or with power supplied from the commercial power supply 22.

One end of the conversion apparatus 14 is connected to the solar battery 10. The path between the conversion apparatus 14 and the solar battery 10 branches at a point, and the branch path is connected to the storage battery 12. Namely, the solar battery 10 and the storage battery 12 are connected in parallel to one end of the conversion apparatus 14 via the branch point. The other end of the conversion apparatus 14 is connected to the commercial power supply 22. The operation of the conversion apparatus 14 will be described later. The management apparatus 16 outputs, to the conversion apparatus 14, an instruction for controlling the operation of the storage battery 12. The conversion apparatus 14 also continuously monitors voltage fluctuation on the path between the first SW 18 and the commercial power supply 22 to determine whether the commercial power supply 22 is failing or supplying power, based on detected voltage fluctuation.

The general load 26 is AC driven electrical equipment. The general load 26 is connected to a path that branches off from the path between the conversion apparatus 14 and the commercial power supply 22. Also, a distribution board, which is not shown in the figures, is connected to a point on the path between the conversion apparatus 14 and the commercial power supply 22, on the commercial power supply 22 side from a branch point at which the path branches off to the commercial power supply 22.

The first SW 18 and the second SW 20 are switches for changing a route according to an instruction from the management apparatus 16. An instruction for turning on or off the first SW 18 or for switching of the second SW 20 is issued by the conversion apparatus 14. Alternatively, such an instruction may be issued by the management apparatus 16. In the normal state, the first SW 18 is turned on, and the second SW 20 is connected to the Y terminal. Accordingly, the Y terminal of the second SW 20 is connected to the specific load 24. As with the general load 26, the specific load 24 is also AC driven electrical equipment.

With regard to charging in the normal state, the charging of the storage battery 12 is performed in the following way. When the electric power company adopts an electricity rate system based on time zones, an electricity rate in the nighttime is set lower than that in the daytime. For example, the daytime may be defined as the period from 7 a.m. to 11 p.m., and the nighttime may be defined as the period from 11 p.m. to 7 a.m. of the following day. In the nighttime, the storage battery 12 is charged with power supplied from the commercial power supply 22 via the first SW 18 and the conversion apparatus 14. In this case, the conversion apparatus 14 converts the AC power received from the commercial power supply 22 into direct-current (DC) power and outputs the DC power to the storage battery 12.

In the daytime, power generated by the solar battery 10 is output to the conversion apparatus 14. In this case, the conversion apparatus 14 converts the DC power received from the solar battery 10 into AC power and outputs the AC power to the first SW 18. Accordingly, the power from the solar battery 10 is also supplied to the specific load 24 and the general load 26. When the amount of power generated by the solar battery 10 is larger than the amount of power consumed by the specific load 24 and general load 26, the excess power is used to charge the storage battery 12.

At the time of discharging in the normal state, the storage battery 12 is used to contribute to so-called "peak cut" for lowering the maximum value of use of commercial power during the daytime in which electricity use is generally increased. Fig. 1B corresponds to a configuration of the power distribution system 100 when the commercial power supply 22 is failing (hereinafter, referred to as a "power failure state"). When power supply from the commercial power supply 22 is stopped, the conversion apparatus 14 detects a power failure. Upon detection of a power failure, the conversion apparatus 14 controls the first SW 18 and the second SW 20. More specifically, in the power failure state, the first SW 18 is turned off, and the second SW 20 is connected to the X terminal. Accordingly, the specific load 24 is connected to the conversion apparatus 14, but the general load 26 is disconnected from the conversion apparatus 14. Consequently, power from the solar battery 10 is output to the conversion apparatus 14, and power from the conversion apparatus 14 is supplied to the specific load 24. When the amount of power consumed by the specific load 24 is smaller than the amount of power from the solar battery 10, the excess power is used to charge the storage battery 12. In the power failure state, the storage battery 12 may be set to output power. In this case, the discharged power is also output to the conversion apparatus 14, and power from the conversion apparatus 14 is supplied to the specific load 24. The storage battery 12 may be used as a storage battery for supplying power to a load in the case where the commercial power supply fails, so that the storage battery 12 may be set not to discharge for the specific load 24 in the normal state but set to discharge for the specific load 24 only in the power failure state.

Thus, the specific load 24 can receive power supply from the solar battery 10, storage battery 12, and commercial power supply 22 in the normal state and from the solar battery 10 and storage battery 12 even in the power failure state. On the other hand, the general load 26 can receive power supply from the solar battery 10, storage battery 12, and commercial power supply 22 in the normal state but cannot receive any power supply in the power failure state.

Fig. 1C corresponds to a configuration of the power distribution system 100 when the commercial power supply 22 has recovered from the power failure state to the state of not failing (hereinafter, referred to as a "recovered state"). When supply of power from the commercial power supply 22 is restored in the power failure state, the conversion apparatus 14 detects a recovery. Upon detection of a recovery, the conversion apparatus 14 controls the second SW 20. More specifically, in the recovered state, the first SW 18 remains turned off, and the second SW 20 is connected to the Y terminal. Accordingly, the specific load 24 and the general load 26 are disconnected from the conversion apparatus 14 and connected to the commercial power supply 22. Consequently, power from the commercial power supply 22 is supplied to the specific load 24 and the general load 26. Since it is not connected to the specific load 24 and general load 26, the conversion apparatus 14 does not output AC power. Meanwhile, power generated by the solar battery 10 is supplied to the storage battery 12.

In the normal state as shown in Fig. 1A, the conversion apparatus 14 performs system cooperative operation. In the power failure state as shown in Fig. 1B or in the recovered state as shown in Fig. 1C, on the other hand, the conversion apparatus 14 performs independent operation. The system cooperative operation is operation performed by the conversion apparatus 14 to generate AC power from DC power using a frequency according to the frequency of power from the commercial power supply 22. On the other hand, the independent operation is operation performed by the conversion apparatus 14 to generate AC power from DC power using a frequency independent of the frequency of power from the commercial power supply 22.

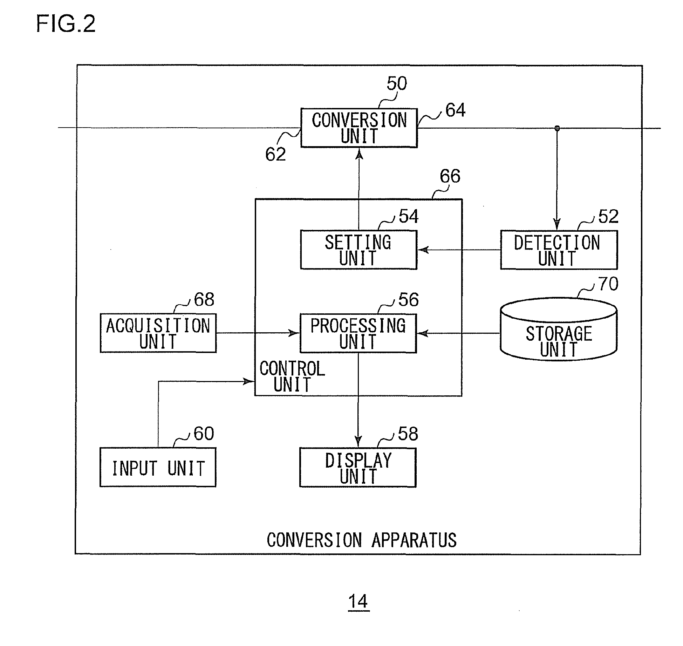

Fig. 2 shows a configuration of the conversion apparatus 14. The conversion apparatus 14 comprises a conversion unit 50, a detection unit 52, a display unit 58, an input unit 60, a control unit 66, an acquisition unit 68, and a storage unit 70. Also, the conversion unit 50 includes a DC-side terminal 62 and an AC-side terminal 64, and the control unit 66 includes a setting unit 54 and a processing unit 56.

The conversion unit 50 is connected to the solar battery 10 and the storage battery 12 shown in Figs. 1A-1C at the DC-side terminal 62 and connected to the first SW 18 shown in Figs. 1A-1C at the AC-side terminal 64. Therefore, the DC-side terminal 62 corresponds to the DC power side, and the AC-side terminal 64 corresponds to the AC power side. The conversion unit 50 receives DC power at the DC-side terminal 62, generates AC power from the DC power, and outputs the AC power via the AC-side terminal 64. The DC power received at the DC-side terminal 62 is provided from the solar battery 10 and the storage battery 12 shown in Figs. 1A-1C.

Also, the conversion unit 50 receives AC power at the AC-side terminal 64, generates DC power from the AC power, and outputs the DC power via the DC-side terminal 62. The AC power received at the AC-side terminal 64 is provided from the commercial power supply 22 via the first SW 18 shown in Figs. 1A-1B. The former function performed by the conversion unit 50 corresponds to an inverter function, and the latter function corresponds to a converter function. Since publicly-known techniques may be used for the inverter function and converter function, a specific description thereof is omitted here. When AC power is generated from DC power, the frequency of the AC power is set by the setting unit 54.

The detection unit 52 receives AC power from the first SW 18, or from the commercial power supply 22, and detects the frequency of the AC power. In the power failure state or the recovered state, since the detection unit 52 does not receive AC power from the commercial power supply 22, the detection unit 52 does not detect the frequency of AC power. When it has detected a frequency, the detection unit 52 outputs information on the detected frequency to the setting unit 54; when it has not detected a frequency, the detection unit 52 outputs information thereon to the setting unit 54.

The setting unit 54 receives, from the detection unit 52, information on a frequency or information on the fact that a frequency has not been detected. Upon reception of information on a frequency, the setting unit 54 sets a frequency according to the frequency in the information, which is namely the frequency of AC power from the commercial power supply 22. In this example, the setting unit 54 sets the same frequency as the frequency of AC power from the commercial power supply 22. Such operation corresponds to the system cooperative operation mentioned previously, and the setting unit 54 defines the operation as a system cooperative mode.

Upon reception of information on the fact that a frequency has not been detected, the setting unit 54 sets a frequency that is independent of the frequency of AC power from the commercial power supply 22 and that has been set in the system cooperative mode performed in the past. Such operation corresponds to the independent operation mentioned previously, and the setting unit 54 defines the operation as an independent mode. In this way, the setting unit 54 sets a frequency of AC power to be generated by the conversion unit 50.

The acquisition unit 68 acquires SOH of the storage battery 12 when a certain amount of power has been discharged from the storage battery 12. The SOH shows a smaller value as the storage battery 12 deteriorates. The SOH is derived as follows.

$$\text{SOH} = (\text{full charge capacity at the time})/(\text{initial full charge capacity}) \qquad (1)$$

The full charge capacity at the time is derived as follows.

$$\text{Full charge capacity at the time} = (\text{factor K}) \times (\text{current integration value I during a predetermined period}) \qquad (2)$$

In the following, a calculation method for Formula (2) will be described.

The factor K is set in advance by measurement or the like. More specifically, the factor K is determined based on a difference amount of state of charge (hereinafter, referred to as "SOC") for a predetermined voltage change. For example, when the predetermined voltage change is defined as a change from a voltage V1 to a voltage V2 (V1>V2) and when V1 corresponds to a voltage when SOC is 75% and V2 corresponds to a voltage when SOC is 50%, the factor K can be determined as follows.

$$\text{Factor K} = 100/(75-50) = 4$$

In addition, when the integration value of current that has flowed during a predetermined period, in which the battery has discharged until the voltage has changed from V1 to V2 (V1>V2), is 10 Ah, the full charge capacity at the time will be as follows.

```
Full charge capacity at the time = 4x10 Ah
```

Since a decreased current can flow as the battery deteriorates, the current integration value is also decreased.

The acquisition unit 68 outputs acquired SOH to the processing unit 56. As described above, unless the voltage changes from V1 to V2, or unless the SOC changes from 75% to 50%, the factor K in Formula (2) cannot be obtained in the present embodiment. Accordingly, unless a certain amount of power is discharged from the storage battery 12 in the normal state, the full charge capacity at the time cannot be obtained, and hence, the SOH cannot be estimated.

The processing unit 56 receives SOH from the acquisition unit 68. The processing unit 56 then compares the SOH with a first threshold value, which is stored in the storage unit 70 and defined based on SOH. For example, it is assumed here that two first threshold values of 63% and 60% are stored. When the SOH is smaller than the larger first threshold value of 63%, the processing unit 56 determines the display of a notice for battery change. Accordingly, the processing unit 56 outputs an instruction for displaying a battery change notice to the display unit 58. Further, when the SOH is even smaller than the smaller first threshold value of 60%, the processing unit 56 determines the display of a warning for battery life. Accordingly, the processing unit 56 outputs an instruction for displaying a battery life warning to the display unit 58.

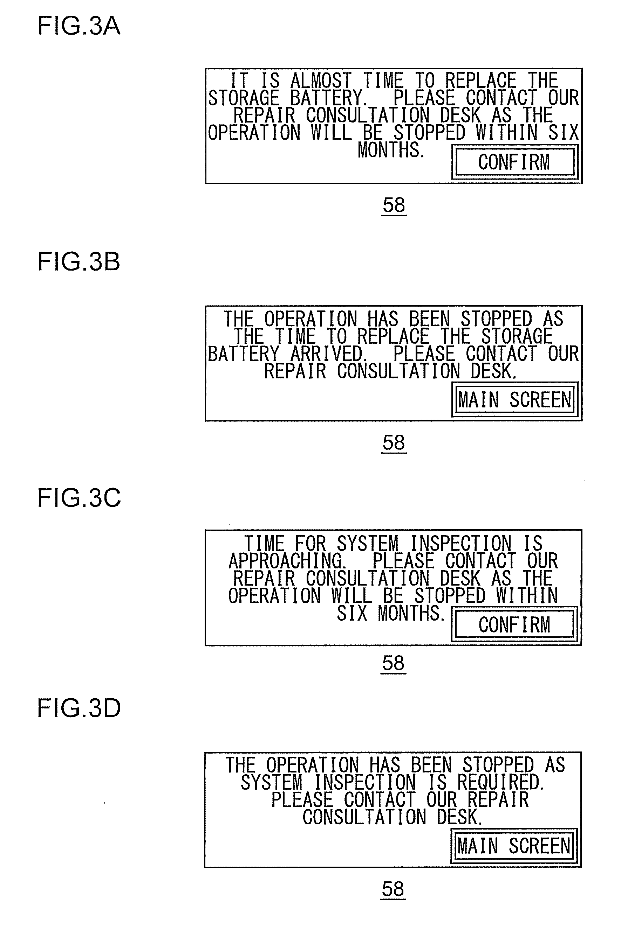

The display unit 58 displays each of various screens according to the process in the processing unit 56. Each of Figs. 3A-3D shows a screen displayed on the display unit 58. Fig. 3A shows a screen displayed when an instruction for displaying a battery change notice is received from the processing unit 56. The screen corresponds to the display of a battery change notice. Fig. 3B shows a screen displayed when an instruction for displaying a battery life warning is received from the processing unit 56. The screen corresponds to the display of a battery life warning. In this way, the display unit 58 provides a notice when the SOH is smaller than the larger first threshold value, and changes the display mode when the SOH smaller than the larger first threshold value is even smaller than the smaller first threshold value. Figs. 3C and 3D will be described later, and the description will now return to Fig. 2.

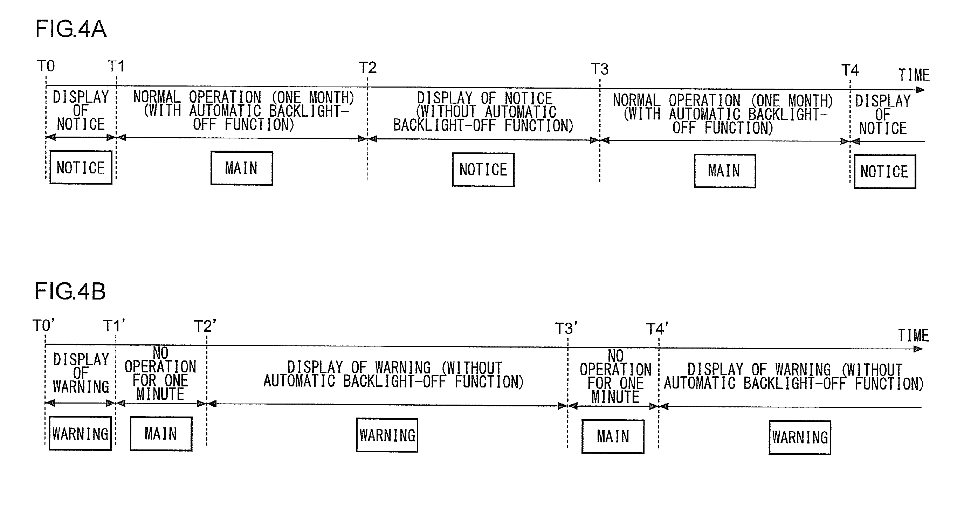

There will be described time courses of the display of a battery change notice and that of a battery life warning on the display unit 58. Each of Figs. 4A and 4B shows a time transition of display on the display unit 58. Fig. 4A shows a time course of the display of a battery change notice. The display unit 58 displays a battery change notice at T0. When a user presses a confirm button at T1, the input unit 60 accepts the input from the user. Upon reception of the input from the user via the input unit 60, the processing unit 56 allows the display unit 58 to display a main screen. Accordingly, the display unit 58 displays the main screen and keeps the normal screen state for one month, with an automatic backlight-off function activated. At T2 after the one month elapses, the display unit 58 displays the battery change notice again. At the time, the automatic backlight-off function is not activated. When the user presses the confirm button at T3, the display unit 58 displays the main screen and keeps the normal screen state for one month in the same way, with the automatic backlight-off function activated. At T4 after the one month elapses, the display unit 58 displays the battery change notice yet again.

Fig. 4B shows a time course of the display of a battery life warning. The display unit 58 displays a battery life warning at T0'. When a user presses a confirm button at T1', the input unit 60 accepts the input from the user. Upon reception of the input from the user via the input unit 60, the processing unit 56 allows the display unit 58 to display a main screen. Accordingly, the display unit 58 displays the main screen. When no operation is provided for one minute, the display unit 58 displays the battery life warning again at T2'. At the time, the automatic backlight-off function is not activated. When the user presses the confirm button at T3', the display unit 58 displays the main screen in the same way. When no operation is provided for one minute, the display unit 58 displays the battery life warning yet again at T4'. In this way, the display unit 58 increases the frequency of notification as the SOH becomes smaller. The description will now return to Fig. 2.

When the acquisition unit 68 has not acquired SOH for a predetermined period, or when discharge control in which SOH cannot be acquired has been provided or SOH has not been able to be acquired because of malfunction of the storage battery 12 for a predetermined period, the processing unit 56 acquires information on the time of manufacture (hereinafter, referred to as a "date of manufacture") of the storage battery 12 from the storage unit 70 or the storage battery 12. For example, the predetermined period may be defined as one year. The storage unit 70 stores the date of manufacture of the storage battery 12.

The processing unit 56 compares the elapsed period from the date of manufacture with a second threshold value, which is stored in the storage unit 70 and defined based on an elapsed period from a date of manufacture. For example, it is assumed here that two second threshold values of 6.5 years and 7 years are stored. When the elapsed period from the date of manufacture is longer than or equal to the smaller second threshold value of 6.5 years, the processing unit 56 determines the display of a battery change notice. Accordingly, the processing unit 56 outputs an instruction for displaying a battery change notice to the display unit 58. Further, when the elapsed period from the date of manufacture is even longer than or equal to the larger second threshold value of 7 years, the processing unit 56 determines the display of a battery life warning. Accordingly, the processing unit 56 outputs an instruction for displaying a battery life warning to the display unit 58. Also, the acquisition unit 68 may acquire an elapsed period from the date of manufacture, and the processing unit 56 may constantly compare the acquired elapsed period from the date of manufacture with a second threshold value. In this case, the processing unit 56 validates the comparison results at the time when a period for which charging or discharging is not performed exceeds a predetermined period, and determines the display of a battery change notice when the elapsed time is longer than or equal to the second threshold value of 6.5 years.

Fig. 3C shows a screen displayed when an instruction for displaying a battery change notice is received from the processing unit 56. The screen corresponds to the display of a battery change notice. Fig. 3D shows a screen displayed when an instruction for displaying a battery life warning is received from the processing unit 56. The screen corresponds to the display of a battery life warning. In this way, the display unit 58 provides a notice when the elapsed period is longer than or equal to the smaller first threshold value, and changes the display mode when the elapsed period longer than the smaller second threshold value is even longer than the larger second threshold value. When Figs. 3A-3B are compared to Figs. 3C-3D, the display unit 58 changes the notification mode, i.e., the display content, according to whether the notice is provided based on the SOH or based on the elapse period. Since the time courses of the display of a battery change notice and that of a battery life warning on the display unit 58 are identical with those shown in Figs. 4A-4B, the description thereof will be omitted. In this case, the display unit 58 increases the frequency of notification as the elapsed period becomes longer. When determining the display of a battery life warning, the processing unit 56 may stop the discharging of the storage battery 12.

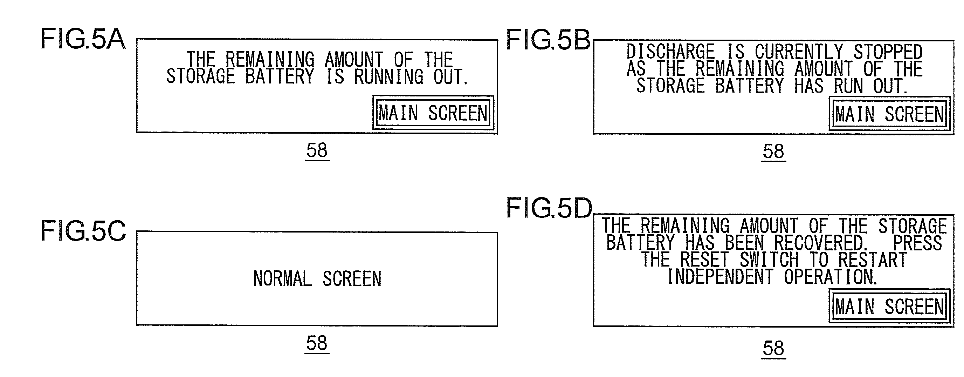

In the above, notification of a battery life has been described. In the following, displaying performed when the remaining amount of the storage battery 12 is running out will be described. Each of Figs. 5A-5D shows a screen displayed on the display unit 58. Fig. 5A shows a screen displayed on the display unit 58 when the remaining time available for discharging is less than 10 minutes. At the time, the SOC is about 17%. Fig. 5B shows a screen displayed on the display unit 58 when the discharging of the storage battery 12 has further proceeded from the state of Fig. 5A and is currently stopped. At the time, the SOC is less than 10%.

Fig. 5C shows a screen displayed on the display unit 58 when the remaining amount of the storage battery 12 has increased from the state of Fig. 5A. The increase of the remaining amount of the storage battery 12 is provided by charging performed by the solar battery 10. It is assumed here that the remaining time available for discharging is increased to 20 minutes or more. Fig. 5D shows a screen displayed on the display unit 58 when the remaining amount of the storage battery 12 has increased from the state of Fig. 5C. The increase of the remaining amount of the storage battery 12 is provided by charging performed by the solar battery 10, and it is also assumed here that the remaining time available for discharging is increased to 20 minutes or more. At the time, the SOC is 24% or above. When a reset switch is pressed while the screen of Fig. 5D is displayed, the screen of Fig. 5C is displayed.

The configuration above may be implemented by a CPU or memory of any given computer, an LSI, or the like in terms of hardware, and by a memory-loaded program or the like in terms of software. In the present embodiment is shown a functional block configuration realized by cooperation thereof. Therefore, it would be understood by those skilled in the art that these functional blocks may be implemented in a variety of forms by hardware only or a combination of hardware and software.

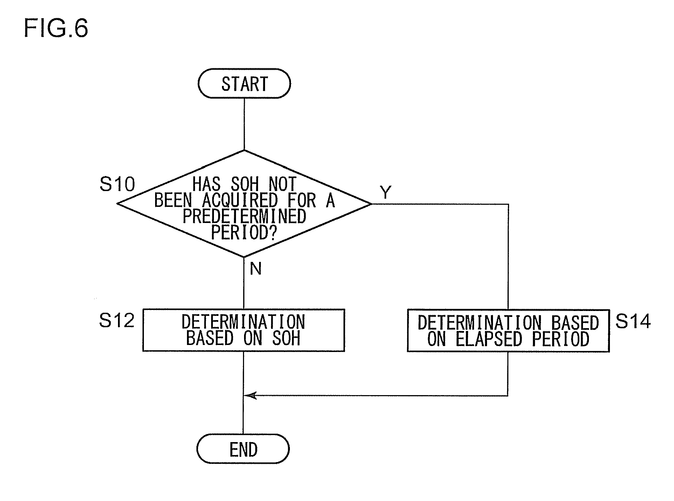

There will now be described an operation performed by the power distribution system 100 having the configuration set forth above. Fig. 6 is a flowchart that shows a procedure of notification of a battery life performed by the conversion apparatus 14. When the acquisition unit 68 has acquired SOH for a predetermined period (N at S10), the processing unit 56 performs determination based on the SOH (S12). On the other hand, when the acquisition unit 68 has not acquired SOH for a predetermined period (Y at S10), the display unit 58 performs determination based on the elapsed period (S14).

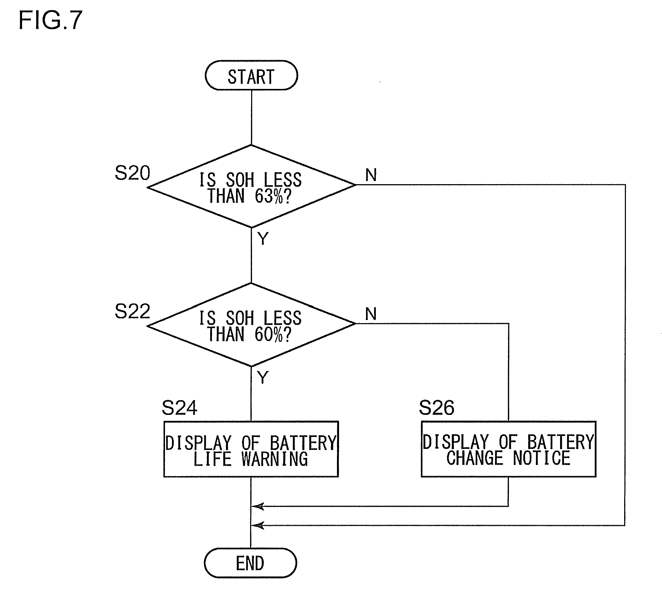

Fig. 7 is a flowchart that shows a procedure of determination based on the SOH. When the SOH is smaller than 63% (Y at S20) and even smaller than 60% (Y at S22), the display unit 58 displays a battery life warning (S24). When the SOH is larger than or equal to 60% (N at S22), the display unit 58 displays a battery change notice (S26). When the SOH is larger than or equal to 63% (N at S20), the processes of steps S22 through S26 are skipped.

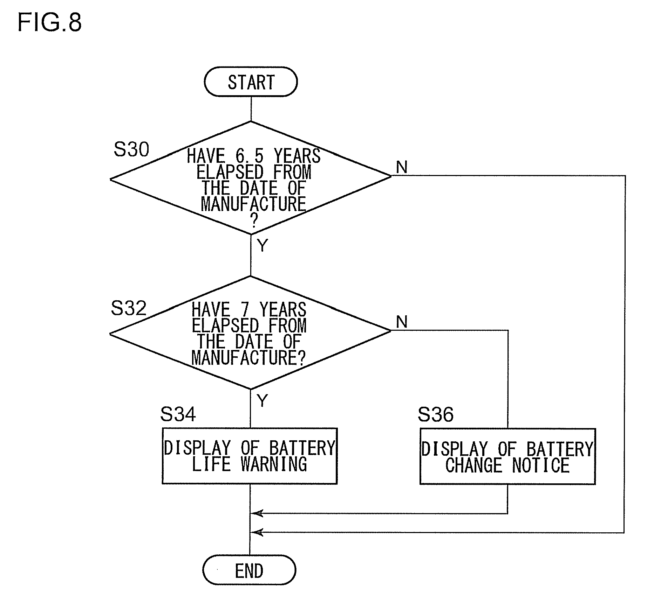

Fig. 8 is a flowchart that shows a procedure of determination based on the elapsed period. When 6.5 years have elapsed from the date of manufacture (Y at S30) and even 7 years have elapsed therefrom (Y at S32), the display unit 58 displays a battery life warning (S34). When the elapsed period from the date of manufacture is shorter than 7 years (N at S32), the display unit 58 displays a battery change notice (S36). When the elapsed period from the date of manufacture is shorter than 6.5 years (N at S30), the processes of steps S32 through S36 are skipped.

According to an embodiment of the present invention, even if SOH cannot be acquired for a predetermined period, a notice is provided based on the elapsed period from the date of manufacture, so that the user can be notified of a degree of deterioration of a storage battery. Since the user can be notified of a degree of deterioration of a storage battery, the situation can be prevented in which the storage battery has reached the end of its life when it needs to be used in an emergency, such as in a power failure. Also, since a battery change notice and a battery life warning are switched to be displayed according to the degree of deterioration, the state of the storage battery can be clearly indicated. When a battery change notice is changed to a battery life warning, the frequency of notification is increased, so that the user can be clearly notified of the risk. In addition, since the notice is changed according to whether the determination is made based on the SOH or based on the elapse period, the user can be notified of the determination criteria.

The present invention has been described with reference to an embodiment. The embodiment is intended to be illustrative only, and it will be obvious to those skilled in the art that various modifications to a combination of constituting elements or processes could be developed and that such modifications also fall within the scope of the present invention.

In an embodiment of the present invention, the solar battery 10 is provided to generate electric power. However, the application is not limited thereto and, for example, besides the solar battery 10, another apparatus for generating electric power from a renewable energy source may be provided. An example may be a wind power generator. This modification allows greater flexibility in the configuration of the power distribution system 100.

In an embodiment of the present invention, notification is performed by displaying a notice on the display unit 58. However, the operation is not limited thereto, and a speaker may be provided so as to perform voice notification, for example. This modification allows greater flexibility in the design of a notification means.

The outline of one embodiment of the present invention is as follows. A control apparatus according to one embodiment of the present invention includes an acquisition unit that acquires state of health of a storage battery provided to supply electric power to a load, in which the state of health shows a smaller value as the storage battery deteriorates, and a notification unit that performs notification when state of health acquired by the acquisition unit is smaller than a first threshold value. When the acquisition unit has not acquired state of health for a predetermined period, the notification unit performs notification if the elapsed period from the manufacture of the storage battery is longer than a second threshold value.

When state of health smaller than the first threshold value becomes even smaller, the notification unit may change the mode of notification.

The notification unit may increase the frequency of notification as the state of health becomes smaller.

When an elapsed period longer than the second threshold value becomes even longer, the notification unit may change the mode of notification.

The control apparatus may further include a processing unit that stops charging and discharging of the storage battery. The processing unit may stop charging and discharging of the storage battery when the notification unit has changed the mode of notification.

The notification unit may increase the frequency of notification as the elapsed period becomes longer.

The notification unit may change the mode of notification according to whether the state of health acquired by the acquisition unit is smaller than the first threshold value or the elapsed period from the manufacture of the storage battery is longer than the second threshold value.

The control apparatus may further include a processing unit that stops charging and discharging of the storage battery. The processing unit may stop charging and discharging of the storage battery when the notification unit has changed the mode of notification.

The acquisition unit may acquire state of health of a storage battery provided to supply electric power to a load in the case where a commercial power supply fails.

Another embodiment of the present invention is a control method. The method includes acquiring state of health of a storage battery provided to supply electric power to a load, in which the state of health shows a smaller value as the storage battery deteriorates, and performing notification when acquired state of health is smaller than a first threshold value. When state of health has not been acquired for a predetermined period in the acquiring, notification is performed in the performing notification if the elapsed period from the manufacture of the storage battery is longer than a second threshold value.

[EXPLANATION OF REFERENCE NUMERALS]

10    solar battery
12    storage battery
14    conversion apparatus
16    management apparatus
18    first SW
20    second SW
22    commercial power supply
24    specific load
26    general load

50      conversion unit
52      detection unit
54      setting unit
56      processing unit
58      display unit
60      input unit
62      DC-side terminal
64      AC-side terminal
66      control unit
68      acquisition unit
70      storage unit
100     power distribution system

[INDUSTRIAL APPLICABILITY]

An embodiment of the present invention enables notification of a degree of deterioration of a storage battery.

**Claims**

1.  A control apparatus, comprising:

    an acquisition unit that acquires state of health of a storage battery provided to supply electric power to a load, the state of health showing a smaller value as the storage battery deteriorates; and
    a notification unit that performs notification when state of health acquired by the acquisition unit is smaller than a first threshold value, wherein,
    when the acquisition unit has not acquired state of health for a predetermined period, the notification unit performs notification if the elapsed period from the manufacture of the storage battery is longer than a second threshold value.

2.  The control apparatus of claim 1, wherein, when state of health smaller than the first threshold value becomes even smaller, the notification unit changes the mode of notification.

3.  The control apparatus of claim 2, wherein the notification unit increases the frequency of notification as the state of health becomes smaller.

4.  The control apparatus of claim 1, wherein, when an elapsed period longer than the second threshold value becomes even longer, the notification unit changes the mode of notification.

5.  The control apparatus of claim 4, further comprising a processing unit that stops charging and discharging of the storage battery, wherein
    the processing unit stops charging and discharging of the storage battery when the notification unit has changed the mode of notification.

6.  The control apparatus of claim 4, wherein the notification unit increases the frequency of notification as the elapsed period becomes longer.

7.  The control apparatus of any one of claims 1 through 4, wherein the notification unit changes the mode of notification according to whether the state of health acquired by the acquisition unit is smaller than the first threshold value or the elapsed period from the manufacture of the storage battery is longer than the second threshold value.

8.  The control apparatus of claim 7, further comprising a processing unit that stops charging and discharging of the storage battery, wherein
    the processing unit stops charging and discharging of the storage battery when the notification unit has changed the mode of notification.

9.  The control apparatus of any one of claims 1 through 8, wherein the acquisition unit acquires state of health of a storage battery provided to supply electric power to a load in the case where a commercial power supply fails.

**10.** A control method, comprising:

acquiring state of health of a storage battery provided to supply electric power to a load, the state of health showing a smaller value as the storage battery deteriorates; and

performing notification when acquired state of health is smaller than a first threshold value, wherein, when state of health has not been acquired for a predetermined period in the acquiring, notification is performed in the performing notification if the elapsed period from the manufacture of the storage battery is longer than a second threshold value.

FIG.1A

```
            ~10
        ┌──────────┐
        │  SOLAR   │
        │ BATTERY  │
        └──────────┘                    18                           22
            ~12          14        ┌──────────┐              ┌─────────────┐
        ┌──────────┐ ┌──────────┐  │ FIRST    │              │ COMMERCIAL  │
        │ STORAGE  │ │CONVERSION│  │  SW      │              │   POWER     │
        │ BATTERY  │ │ APPARATUS│  │  o   o   │              │   SUPPLY    │
        └──────────┘ └──────────┘  └──────────┘              └─────────────┘
                         ↑                    ┌──────────┐
                       ~16                    │ X    Y   │  20
                  ┌────────────┐              │ o    o   │
                  │ MANAGEMENT │              │  SECOND  │
                  │ APPARATUS  │              │    SW    │
                  └────────────┘              └──────────┘
                                                 ~24            ~26
                                          ┌──────────┐    ┌──────────┐
                                          │ SPECIFIC │    │ GENERAL  │
                                          │   LOAD   │    │   LOAD   │
                                          └──────────┘    └──────────┘
                                               100
```

FIG.1B

```
            ~10
        ┌──────────┐
        │  SOLAR   │
        │ BATTERY  │
        └──────────┘                    18                           22
            ~12          14        ┌──────────┐              ┌─────────────┐
        ┌──────────┐ ┌──────────┐  │ FIRST    │              │ COMMERCIAL  │
        │ STORAGE  │ │CONVERSION│  │  SW      │              │   POWER     │
        │ BATTERY  │ │ APPARATUS│  │  o   o   │              │   SUPPLY    │
        └──────────┘ └──────────┘  └──────────┘              └─────────────┘
                         ↑                    ┌──────────┐
                       ~16                    │ X    Y   │  20
                  ┌────────────┐              │ o    o   │
                  │ MANAGEMENT │              │  SECOND  │
                  │ APPARATUS  │              │    SW    │
                  └────────────┘              └──────────┘
                                                 ~24            ~26
                                          ┌──────────┐    ┌──────────┐
                                          │ SPECIFIC │    │ GENERAL  │
                                          │   LOAD   │    │   LOAD   │
                                          └──────────┘    └──────────┘
                                               100
```

FIG.1C

```
            ~10
        ┌──────────┐
        │  SOLAR   │
        │ BATTERY  │
        └──────────┘                    18                           22
            ~12          14        ┌──────────┐              ┌─────────────┐
        ┌──────────┐ ┌──────────┐  │ FIRST    │              │ COMMERCIAL  │
        │ STORAGE  │ │CONVERSION│  │  SW      │              │   POWER     │
        │ BATTERY  │ │ APPARATUS│  │  o   o   │              │   SUPPLY    │
        └──────────┘ └──────────┘  └──────────┘              └─────────────┘
                         ↑                    ┌──────────┐
                       ~16                    │ X    Y   │  20
                  ┌────────────┐              │ o    o   │
                  │ MANAGEMENT │              │  SECOND  │
                  │ APPARATUS  │              │    SW    │
                  └────────────┘              └──────────┘
                                                 ~24            ~26
                                          ┌──────────┐    ┌──────────┐
                                          │ SPECIFIC │    │ GENERAL  │
                                          │   LOAD   │    │   LOAD   │
                                          └──────────┘    └──────────┘
                                               100
```

FIG.2

CONVERSION APPARATUS

14

## FIG.3A

IT IS ALMOST TIME TO REPLACE THE
STORAGE BATTERY.  PLEASE CONTACT OUR
REPAIR CONSULTATION DESK AS THE
OPERATION WILL BE STOPPED WITHIN SIX
MONTHS.

| CONFIRM |

58

## FIG.3B

THE OPERATION HAS BEEN STOPPED AS
THE TIME TO REPLACE THE STORAGE
BATTERY ARRIVED.  PLEASE CONTACT OUR
REPAIR CONSULTATION DESK.

| MAIN SCREEN |

58

## FIG.3C

TIME FOR SYSTEM INSPECTION IS
APPROACHING.  PLEASE CONTACT OUR
REPAIR CONSULTATION DESK AS THE
OPERATION WILL BE STOPPED WITHIN
SIX MONTHS.

| CONFIRM |

58

## FIG.3D

THE OPERATION HAS BEEN STOPPED AS
SYSTEM INSPECTION IS REQUIRED.
PLEASE CONTACT OUR REPAIR
CONSULTATION DESK.

| MAIN SCREEN |

58

## FIG.4A

| T0 | T1 | | T2 | | T3 | | T4 | TIME |
|---|---|---|---|---|---|---|---|---|

DISPLAY OF NOTICE | NORMAL OPERATION (ONE MONTH) (WITH AUTOMATIC BACKLIGHT-OFF FUNCTION) | DISPLAY OF NOTICE (WITHOUT AUTOMATIC BACKLIGHT-OFF FUNCTION) | NORMAL OPERATION (ONE MONTH) (WITH AUTOMATIC BACKLIGHT-OFF FUNCTION) | DISPLAY OF NOTICE

NOTICE | MAIN | NOTICE | MAIN | NOTICE

## FIG.4B

| T0' | T1' | T2' | | T3' | T4' | | TIME |
|---|---|---|---|---|---|---|---|

DISPLAY OF WARNING | NO OPERATION FOR ONE MINUTE | DISPLAY OF WARNING (WITHOUT AUTOMATIC BACKLIGHT-OFF FUNCTION) | NO OPERATION FOR ONE MINUTE | DISPLAY OF WARNING (WITHOUT AUTOMATIC BACKLIGHT-OFF FUNCTION)

WARNING | MAIN | WARNING | MAIN | WARNING

EP 2 857 855 A1

FIG.5A

THE REMAINING AMOUNT OF THE
STORAGE BATTERY IS RUNNING OUT.

MAIN SCREEN

58

FIG.5B

DISCHARGE IS CURRENTLY STOPPED
AS THE REMAINING AMOUNT OF THE
STORAGE BATTERY HAS RUN OUT.

MAIN SCREEN

58

FIG.5C

NORMAL SCREEN

58

FIG.5D

THE REMAINING AMOUNT OF THE STORAGE
BATTERY HAS BEEN RECOVERED. PRESS
THE RESET SWITCH TO RESTART
INDEPENDENT OPERATION.

MAIN SCREEN

58

FIG.6

```
                    ┌─────────┐
                    │  START  │
                    └────┬────┘
                         │
              ╱──────────┴──────────╲
S10         ╱    HAS SOH NOT          ╲         Y
          ╱   BEEN ACQUIRED FOR A       ╲─────────────────────┐
          ╲      PREDETERMINED         ╱                       │
            ╲      PERIOD?           ╱                         │
              ╲──────────┬──────────╱                          │
                         │ N                                   │
                         │                                     │
S12  ┌───────────────────┴─────┐         ┌─────────────────────┴──┐ S14
     │    DETERMINATION        │         │  DETERMINATION BASED    │
     │    BASED ON SOH         │         │   ON ELAPSED PERIOD     │
     └───────────┬─────────────┘         └────────────┬───────────┘
                 │                                     │
                 │◄────────────────────────────────────
                 │
           ┌─────┴─────┐
           │    END    │
           └───────────┘
```

# FIG.7

```
                    ┌─────────┐
                    │  START  │
                    └─────────┘
                         │
                        ╱╲
         S20          ╱    ╲              N
                    ╱ IS SOH ╲ ────────────────────────┐
                    ╲ LESS    ╱                         │
                     ╲THAN 63%╱                         │
                       ╲    ╱                           │
                        ╲╱                              │
                         │ Y                            │
                        ╱╲                              │
         S22          ╱    ╲              N             │
                    ╱ IS SOH ╲ ──────────────┐         │
                    ╲ LESS    ╱               │         │
                     ╲THAN 60%╱               │         │
                       ╲    ╱                 │         │
                        ╲╱                    │         │
                         │ Y                  │         │
         S24             │          S26       │         │
      ┌──────────────────┐      ┌──────────────────┐    │
      │ DISPLAY OF BATTERY│      │ DISPLAY OF BATTERY│   │
      │  LIFE WARNING     │      │  CHANGE NOTICE    │   │
      └──────────────────┘      └──────────────────┘    │
                 │                        │              │
                 │◄───────────────────────┘              │
                 │◄──────────────────────────────────────┘
            ┌─────────┐
            │   END   │
            └─────────┘
```

# FIG.8

START

S30 HAVE 6.5 YEARS ELAPSED FROM THE DATE OF MANUFACTURE ? — N

Y

S32 HAVE 7 YEARS ELAPSED FROM THE DATE OF MANUFACTURE? — N

Y

S34 DISPLAY OF BATTERY LIFE WARNING

S36 DISPLAY OF BATTERY CHANGE NOTICE

END

<table>
<tr><td colspan="2" align="center">**INTERNATIONAL SEARCH REPORT**</td><td>International application No.<br>PCT/JP2012/003605</td></tr>
</table>

A. CLASSIFICATION OF SUBJECT MATTER
*G01R31/36*(2006.01)i

According to International Patent Classification (IPC) or to both national classification and IPC

B. FIELDS SEARCHED

Minimum documentation searched (classification system followed by classification symbols)
G01R31/36

Documentation searched other than minimum documentation to the extent that such documents are included in the fields searched

| | | |
|---|---|---|
| Jitsuyo Shinan Koho | 1922–1996 | Jitsuyo Shinan Toroku Koho  1996–2012 |
| Kokai Jitsuyo Shinan Koho | 1971–2012 | Toroku Jitsuyo Shinan Koho  1994–2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2004-271532 A  (Omron Corp.),<br>30 September 2004 (30.09.2004),<br>entire text; all drawings<br>(Family: none) | 1–10 |
| A | JP 2007-187533 A  (Sanyo Electric Co., Ltd.),<br>26 July 2007 (26.07.2007),<br>entire text; all drawings<br>(Family: none) | 1–10 |
| A | JP 2004-22183 A  (Toyota Motor Corp.),<br>22 January 2004 (22.01.2004),<br>entire text; all drawings<br>& US 2003/0231006 A1    & DE 10325751 A<br>& FR 2841385 A | 1–10 |

☐ Further documents are listed in the continuation of Box C.     ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>20 August, 2012 (20.08.12) | Date of mailing of the international search report<br>28 August, 2012 (28.08.12) |
|---|---|
| Name and mailing address of the ISA/<br>Japanese Patent Office | Authorized officer |
| Facsimile No. | Telephone No. |

Form PCT/ISA/210 (second sheet) (July 2009)

**EP 2 857 855 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005321983 A